# EUROPEAN PATENT APPLICATION

(11) **EP 4 614 810 A1**
(43) Date of publication of application: **10.09.2025**
(21) Application number: 24832361.0
(22) Date of filing: 19.06.2024
(51) Int. Cl.: H02S 50/00, H02S 40/30, H03F 3/26

(54) **APPARATUS AND METHOD FOR CONTROLLING PHOTOVOLTAIC MODULE**

(30) Priority: 28.06.2023 KR 20230083789
(71) Applicant: Hanwha Solutions Corporation, Jung-gu Seoul 04541 (KR)
(72) Inventor: LEE, Kang Min, Seoul 04541 (KR); KIM, Jeong Hwan, Seoul 04541 (KR); BANG, Young Gyun, Seoul 04541 (KR); GONG, Tae Su, Seoul 04541 (KR); KANG, Hyeon Min, Seoul 04541 (KR); KIM, Min Ho, Seoul 04541 (KR)
(74) Representative: Mooser, Sebastian Thomas
(86) International application number: PCT/KR2024/008481
(87) International publication number: WO 2025/005582

(57) **Abstract**

A device for controlling photovoltaic modules according to one aspect includes: a communication unit configured to receive data from a plurality of photovoltaic modules included in a plurality of photovoltaic module arrays; and a processor configured to monitor and control an operation status of the plurality of photovoltaic modules based on data received through the communication unit, wherein the communication unit may include a coupling unit that connects the plurality of photovoltaic module arrays to the processor in a many-to-one manner.

## Description

### Technical Field

The present disclosure relates to a device and method of controlling a photovoltaic module. More particularly, the present disclosure relates to a device and method of controlling a photovoltaic module based on power line communication.

### Background Art

Photovoltaic power generation systems that convert photovoltaic energy into electrical energy have been applied in various fields.

In some embodiments, there are still limitations to managing power generation efficiency at the level of a photovoltaic module (PV Module) included in a photovoltaic power generation system.

In some embodiments, power generation performance may deteriorate as whitening, electrode corrosion, and insulation breakdown occur in a photovoltaic module. Accordingly, the demands for methods to easily and quickly detect a deterioration in the power generation performance of photovoltaic modules and to extend the life of photovoltaic modules have increased.

In some embodiments, when an abnormality is detected in a photovoltaic module array (PV Array) in which photovoltaic modules are connected, it may be difficult to clearly detect which photovoltaic module has malfunctioned.

If the malfunction of the photovoltaic module is not dealt with in advance, the photovoltaic power generation systems may not operate properly, resulting in economic losses.

Therefore, a method to control and monitor the photovoltaic module more easily is needed.

### Disclosure of Invention

### Technical Problem

The disclosure provides a device and method of controlling a photovoltaic module. In some embodiments, the disclosure provides a computer-readable recording medium having recorded thereon a program for causing a computer to execute the method. The technical problems to be achieved are not limited to the technical problems described above, and other technical problems may exist.

### Solution to Problem

A device for controlling photovoltaic modules according to one aspect includes: a communication unit configured to receive data from a plurality of photovoltaic modules included in a plurality of photovoltaic module arrays; and a processor configured to monitor and control an operation status of the plurality of photovoltaic modules based on data received through the communication unit, wherein the communication unit may include a coupling unit that connects the plurality of photovoltaic module arrays to the processor in a many-to-one manner.

A method of controlling photovoltaic modules according to another aspect includes: receiving, by a communication unit, data from a plurality of photovoltaic modules included in a plurality of photovoltaic module arrays; determining, by the processor, the operation status of the photovoltaic modules based on data received through the communication unit; and controlling, by the processor, an output unit to output a screen indicating the operation status of the photovoltaic modules, wherein the communication unit may connect the plurality of photovoltaic module arrays to the processor in a many-to-one manner through the coupling unit.

A computer-readable recording medium according to another aspect may include a recording medium having recorded thereon a program for causing a computer to execute the method.

### Advantageous Effects of Invention

The status of photovoltaic modules may be easily identified. In some embodiments, the complexity of control and communication for photovoltaic modules may be reduced, and communication quality within the photovoltaic system may be improved.

### Brief Description of Drawings

FIG. 1 is a diagram illustrating an example of a plurality of photovoltaic module arrays and a control device according to an embodiment.
FIG. 2 is a diagram for explaining an example of a power supply structure of a building in which photovoltaic modules are installed according to an embodiment.
FIG. 3 is a block diagram illustrating an example of a control device according to an embodiment.
FIG. 4 is a diagram illustrating an example of a power line connection configuration of a communication unit of the control device according to an embodiment.
FIG. 5 is a diagram illustrating an example of a system including the control device, the photovoltaic module, the photovoltaic module array, and an inverter according to an embodiment.
FIG. 6 is a diagram illustrating an example of the communication unit and a processor of a control device according to an embodiment.
FIG. 7 is a diagram illustrating an example of the control device including a signal amplifier according to an embodiment.
FIG. 8 is a diagram illustrating another example of the control device including the signal amplifier according to an embodiment.
FIG. 9 is a flowchart illustrating an example of a method of controlling photovoltaic modules according to an embodiment.
FIG. 10 is a flowchart illustrating another example of a method of controlling photovoltaic modules according to an embodiment.
FIG. 11 is a diagram illustrating an example of a monitoring screen regarding an integrated control device for photovoltaic modules according to an embodiment.

### Best mode for Carrying out the Invention

A device for controlling photovoltaic modules according to one aspect includes: a communication unit configured to receive data from a plurality of photovoltaic modules included in a plurality of photovoltaic module arrays; and a processor configured to monitor and control an operation status of the plurality of photovoltaic modules based on data received through the communication unit, wherein the communication unit may include a coupling unit that connects the plurality of photovoltaic module arrays to the processor in a many-to-one manner.

### Mode for the Invention

Although the terms used in the embodiments are selected, as much as possible, from general terms that are widely used at present, these terms may be replaced by other terms based on intentions of one of ordinary skill in the art, customs, emergence of new technologies, or the like. In a particular case, terms that are arbitrarily selected by the applicant may be used. In this case, the meanings of these terms may be described in corresponding parts of the embodiments. Therefore, it is noted that the terms used in this description are construed based on practical meanings thereof and the whole content of this description, rather than being simply construed based on names of the terms.

When it is stated that a certain part "includes" a certain component throughout the specification, it means that, unless specifically stated otherwise, it does not exclude other components but can include additional components.

The terms that include ordinal numbers, such as "first" or "second," used in this description may be used to describe various components, but the components are not limited by the terms. These terms may be used to distinguish one component from another.

Hereinafter, a preferred embodiment of the present disclosure will be described with reference to the accompanying drawings. The description that will be described below with the accompanying drawings is to describe exemplary embodiments of the present disclose, and is not intended to describe the only embodiment in which the present disclose may be implemented. In order to clearly explain the present disclosure in the drawings, parts that are not related to the description may be omitted, and the same reference numerals may be used for identical or similar components throughout the specification.

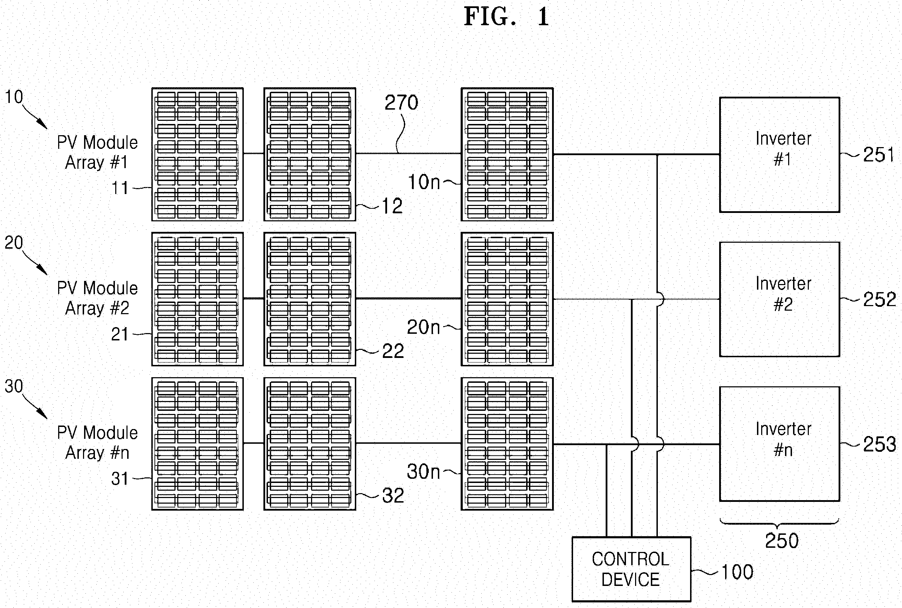

FIG. 1 is a diagram illustrating an example of a plurality of photovoltaic module arrays and a control device according to an embodiment.

Referring to FIG. 1, the plurality of photovoltaic modules 11 through 10n, 21 through 20n, and 31 through 30n may be interconnected to form photovoltaic module arrays 10, 20, and 30.

For example, the plurality of photovoltaic modules 11 through 10n, 21 through 20n, and 31 through 30n may be connected to each other through power lines 270.

For example, the photovoltaic module arrays 10, 20, and 30 may be connected to inverters 251, 252, and 253, respectively. Inverters 250 may convert direct current power generated from the photovoltaic module arrays 10, 20, and 30 into alternating current power.

In some embodiments, the plurality of the photovoltaic module arrays 10, 20, and 30 may each be connected to the control device 100 to transmit and receive data. For example, the plurality of photovoltaic modules 11 through 10n, 21 through 20n, and 31 through 30n may transmit and receive data to and from the control device 100 through power line communication (PLC).

Power line communication is a communication method that transmits data through power lines (e.g. cables) that supply electricity. For example, in the case of power line communication, communication may be performed by carrying data in a frequency signal through power lines that supply power. Power line communication may be divided into high-speed and low-speed based on communication speed, and high-voltage and low-voltage based on communication voltage. For example, home photovoltaic modules and control devices may communicate using a frequency band of 50 Hz to 60 Hz, but are not limited thereto.

The first photovoltaic module array 10 may include a first group of photovoltaic modules 11 through 10n. In some embodiments, the first photovoltaic module array 10 may be connected to a first inverter 251.

The second photovoltaic module array 20 may include a second group of photovoltaic modules 21 through 20n. In some embodiments, the second photovoltaic module array 20 may be connected to a second inverter 252.

The third photovoltaic module array 30 may include a third group of photovoltaic modules 31 through 30n. In some embodiments, the third photovoltaic module array 30 may be connected to a third inverter 253.

In FIG. 1, a total of three photovoltaic module arrays are illustrated, but are not limited thereto. According to the needs, the number of photovoltaic module arrays included in a photovoltaic power generation systems may vary.

In some embodiments, FIG. 1 illustrates that the photovoltaic modules included in the photovoltaic module array are connected in series, but is not limited thereto. In other words, photovoltaic modules may be connected in parallel with each other.

For example, a photovoltaic module string may be formed by connecting photovoltaic modules in series. In some embodiments, the photovoltaic module array may be formed by connecting photovoltaic module strings in parallel.

The photovoltaic modules 11 through 10n, 21 through 20n, and 31 through 30n may each be connected to a converter, and a plurality of converters may be connected to inverters 250.

The inverters 250 and the control device 100 may be connected to the photovoltaic modules 11 through 10n, 21 through 20n, and 31 through 30n and the photovoltaic module arrays 10, 20, and 30 commonly through the power line 270.

The inverters 250 may combine and convert energy (e.g., direct current power) generated from photovoltaic modules 11 through 10n, 21 through 20n, and 31 through 30n and the photovoltaic module arrays 10, 20, and 30.

The control device 100 may transmit and receive data to and from photovoltaic modules 11 through 10n, 21 through 20n, and 31 through 30n and the photovoltaic module arrays 10, 20, and 30 through the power line 270. Accordingly, the control device 100 may receive data from photovoltaic modules 11 through 10n, 21 through 20n, and 31 through 30n and the photovoltaic module arrays 10, 20, and 30.

Even if the control device 100 does not include multiple modules (e.g., controllers) for collecting data for each of the photovoltaic module arrays 10, 20, and 30 or each of the photovoltaic modules 11 through 10n, 21 through 20n, and 31 through 30n, the control device 100 may be connected to the photovoltaic module arrays 10, 20, and 30 through the coupling unit 70. That is, the coupling unit 70 may connect the photovoltaic module arrays 10, 20, and 30 to the processor 110 in a many-to-one manner.

Accordingly, one control device 100 may directly receive and process data from the photovoltaic module arrays 10, 20, and 30. Therefore, the complex communication structure in the existing photovoltaic power generation systems may be improved.

The control device 100 may identify the operation status and control the operation of each of the photovoltaic module arrays 10, 20, and 30. In some embodiments, the control device 100 may identify the operation status and control the operation of each of the photovoltaic modules 11 through 10n, 21 through 20n, and 31 through 30n.

Therefore, the control device 100 may quickly process data for each of the photovoltaic module arrays 10, 20, and 30 and each of the photovoltaic modules 11 through 10n, 21 through 20n, and 31 through 30n.

The control device 100 may monitor the amount of power generation and operation status of each of the photovoltaic modules 11 through 10n, 21 through 20n, and 31 through 30n based on data received from photovoltaic modules 11 through 10n, 21 through 20n, and 31 through 30n.

The control device 100 may identify whether a malfunction has occurred in the photovoltaic module by receiving a malfunction signal through a module level power conversion device (or Module Level Power Electronics) (hereinafter referred to as "MLPE") of each of the photovoltaic modules 11 through 10n, 21 through 20n, and 31 through 30n. In some embodiments, when a malfunction occurs in at least one of the photovoltaic modules 11 through 10n, 21 through 20n, and 31 through 30n, the control device 100 may quickly transmit a control signal to the malfunctioning photovoltaic module to stop operation according to the operation status of the malfunctioning photovoltaic module.

In some embodiments, when a malfunction occurs in at least one of the photovoltaic modules 11 through 10n, 21 through 20n, and 31 through 30n, the control device 100 may individually control each of the photovoltaic modules 11 through 10n, 21 through 20n, and 31 through 30n.

For example, an MLPE may be an optimizer or a micro inverter.

As an example, when the MLPE is the optimizer, photovoltaic power generation systems may include a single inverter. In this case, a single MLPE may be connected to a single photovoltaic module, and the MLPE may optimize the power output from a single photovoltaic module and output it to a single inverter (e.g., a string inverter). The power converted by the inverter (e.g., converting direct current power into alternating current power) may be output to a load or grid.

As another example, when the MLPE is a microinverter, a single MLPE may be connected to a single photovoltaic module. In this case, the MLPE may convert the power generated from a single photovoltaic module, and the converted power may be output to a load or grid.

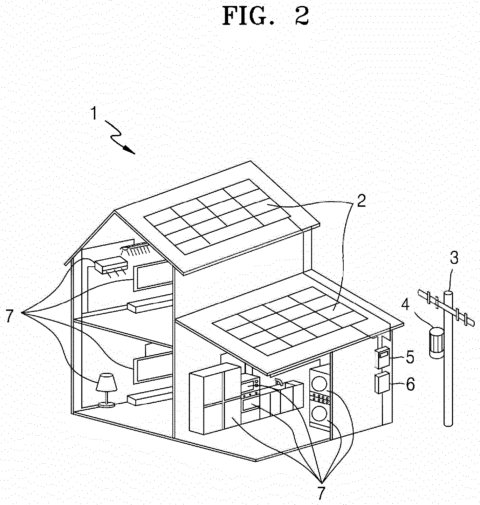

FIG. 2 is a diagram for explaining an example of a power supply structure of a building in which photovoltaic modules are installed according to an embodiment.

Referring to FIG. 2, photovoltaic modules 2 may be installed on the roof of a building to generate power. As described above with reference to FIG. 1, the photovoltaic modules 2 may form at least one photovoltaic module array.

The inverter 6 may convert power generated from photovoltaic modules and supply it to a building 1.

In some embodiments, commercial power transmitted through the power pole 3 may be supplied to the building through the transformer 4.

A plurality of home appliances 7 may be operated by selectively receiving at least one of commercial power or power generated by photovoltaic modules 2. The power meter 5 may measure the amount of power consumed in the building 1.

In some embodiments, when a separate energy storage system (ESS) is installed in the building 1, the power generated from the photovoltaic modules 2 may be stored in the energy storage system (ESS).

The photovoltaic modules 2 may form at least one photovoltaic module array. For example, the photovoltaic module array may include one output terminal.

In some embodiments, the photovoltaic modules 2 may include MLPE.

For example, the MLPE device may monitor the status or power generation of photovoltaic modules 2 and transmit data to an external device.

In some embodiments, the MLPE may perform Rapid Shutdown (RSD) and stop the operation of the photovoltaic module according to a degree of malfunction of the photovoltaic module.

In some embodiments, at least one of the photovoltaic modules 2 and the MLPEs may include a communication module for power line communications.

The control device 100 may receive data from at least one photovoltaic module array through power line communication.

For example, the control device 100 may receive data about the photovoltaic modules 2 from the MLPE provided in each of the photovoltaic modules 2.

The control device 100 may monitor the amount of power generation and operation status of the photovoltaic modules 2 based on the received data.

In some embodiments, when the rapid shutdown function of the MLPE is executed, the control device 100 may receive a malfunction signal and identify a malfunction of the photovoltaic module. In some embodiments, when a malfunction occurs in a photovoltaic module, the control device 100 may transmit a control signal to the corresponding photovoltaic module to stop operation according to the operation status of the photovoltaic module.

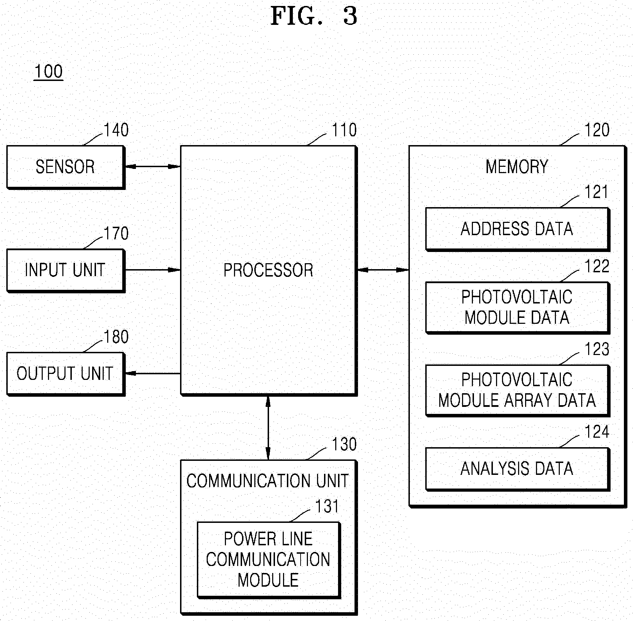

FIG. 3 is a block diagram illustrating an example of a control device according to an embodiment.

Referring to FIG. 3, the control device 100 may include a sensor 140, an input unit 170, an output unit 180, the communication unit 130, a memory 120, and the processor 110.

For example, the sensor 140 may include at least one sensor. The sensor 140 may transmit detected data to the processor 110. The sensor 140 may detect the connection status of the power line (communication line) by measuring the current or voltage flowing through the power line (communication line). In some embodiments, the sensor 140 may detect whether an object is heated based on the measured temperature.

For example, the input unit 170 may include at least one input means among a switch and a button. Setting data or control data about the plurality of photovoltaic modules or the plurality of photovoltaic module arrays may be input through the input unit 170.

For example, the output unit 180 may include at least one of a lamp, a display, and a speaker. The output unit 180 may output data received from photovoltaic modules or photovoltaic module arrays.

In some embodiments, when a malfunction occurs in at least one of the photovoltaic modules or photovoltaic module arrays, the output unit 180 may output a notification or warning. For example, the output unit 180 may output data detected through the sensor 140 and output a warning when an abnormality occurs in at least one module of photovoltaic power generation systems.

The memory 120 may store data about the photovoltaic modules or photovoltaic module arrays.

For example, the memory 120 may store data about the individual photovoltaic modules or individual photovoltaic module arrays. In some embodiments, the memory 120 may store data about the capacitance, installation date, malfunction history, cumulative production, and cumulative operation days of each photovoltaic module.

For example, the memory 120 may store address data 121, photovoltaic module data 122, photovoltaic module array data 123, and analysis data 124.

Address data 121 includes address information assigned to each photovoltaic module and may be used as an identifier for the photovoltaic module. Photovoltaic module data 122 may include data about the amount of power generation, operation status, etc. of the photovoltaic module. Photovoltaic module array data 123 may include information about the photovoltaic module array, information about the photovoltaic modules included in the photovoltaic module array, and information about the total amount of power generation of the photovoltaic module array.

The analysis data 124 may include statistical data about data for the photovoltaic module and data for the photovoltaic module array. For example, the analysis data 124 may include not only data about the total amount of power generated from photovoltaic modules, but also statistical data by hour, day, month, and year.

The memory 120 may store data about one of an energy management algorithm, a photovoltaic module control algorithm, a photovoltaic module array control algorithm, a data processing algorithm, and a parallel communication control algorithm.

For example, the memory 120 may include a nonvolatile memory such as RAM (Random Access Memory), ROM, EEPROM (Electrically Erased Programmable ROM), and a storage means such as flash memory.

The communication unit 130 includes a wired or wireless communication module. For example, the communication unit 130 may include a power line communication module (PLC Module) 131. In some embodiments, the communication unit 130 may perform communication according to at least one of short-distance communication, mobile communication, and serial communication, and the short-distance communication includes Ethernet, WIFI, Bluetooth, or Near Field Communication (NFC).

For example, the communication unit 130 may communicate with photovoltaic modules or photovoltaic module arrays.

The communication unit 130 may transmit and receive data to and from each of the photovoltaic modules by forming a parallel communication circuit.

In some embodiments, the communication unit 130 may communicate with external servers, management servers, and administrator terminals. For example, the communication unit 130 may receive weather information from a weather server and past power generation data from a management server.

The processor 110 may process data for photovoltaic modules and photovoltaic module arrays and control operations by operating according to an algorithm stored in the memory 120.

The processor 110 may analyze data for photovoltaic modules received through the communication unit 130 and generate a monitoring screen regarding the operation status of photovoltaic modules. In some embodiments, the processor 110 may control the output unit 180, and thus, the monitoring screen may be output.

The processor 110 may distinguish each photovoltaic module based on the received data and control the output unit 180, and thus, the amount of power generated by each photovoltaic module may be output.

The processor 110 may calculate the total amount of power of photovoltaic module arrays and control the output unit 180, and thus, the total amount of power may be output. In some embodiments, the processor 110 may also calculate the average amount of power for each photovoltaic module.

The processor 110 may determine whether a malfunction has occurred in a photovoltaic module in response to the malfunction signal received from at least one of the photovoltaic modules. For example, the processor 110 may control the output unit 180 to output a screen in which the color of a malfunctioning photovoltaic module changes or letters are displayed differently. In some embodiments, the processor 110 may control the output unit 180 to output a warning about the malfunctioning photovoltaic module.

The processor 110 may distinguish data for each photovoltaic module and store the data in the memory 120. The processor 110 may determine the operation status of each photovoltaic module based on data stored for each photovoltaic module.

The processor 110 may individually control the photovoltaic modules, and thus, the only remaining photovoltaic modules operate among all photovoltaic modules, excluding the photovoltaic modules determined to be a malfunction (i.e. a malfunctioning photovoltaic module).

When the malfunction signal due to rapid shutdown is received from the failed photovoltaic module, the processor 110 may identify the malfunctioning photovoltaic module. The processor 110 may control the output unit 180 to output a notification or warning about the malfunctioning photovoltaic module.

For example, the processor 110 may process commands of a computer program by performing basic arithmetic, logic, and input/output operations. In this regard, the command may be provided from the memory 120 or an external device. In some embodiments, the processor 110 may generally control the operation of other components included in the control device 100.

In some embodiments, the processor 110 may perform at least some of the data analysis, processing, and result information generation for performing the above described operations by using at least one of a machine learning, neural network, or deep learning algorithm as a rule-based or artificial intelligence algorithm. Examples of neural networks are models such as Convolutional Neural Network (CNN), Deep Neural Network (DNN), and Recurrent Neural Network (RNN).

For example, the processor 110 may be implemented as an array of a number of logic gates, or may be implemented as a combination of a general purpose microprocessor and a memory storing a program that may be executed on the microprocessor. For example, the processor 110 may include a general purpose processor, a central processing unit (CPU), a microprocessor, a digital signal processor (DSP), a controller, a microcontroller, a state machine, and the like. In some environments, the processor 110 may include an application specific integrated circuit (ASIC), a programmable logic device (PLD), a field programmable gate array (FPGA), and the like. For example, the processor 110 may refer to a combination of processing devices, such as a combination of a digital signal processor (DSP) and a microprocessor, a combination of a plurality of microprocessors, a combination of one or more microprocessors combined with a digital signal processor (DSP) core, or a combination of any other such configurations.

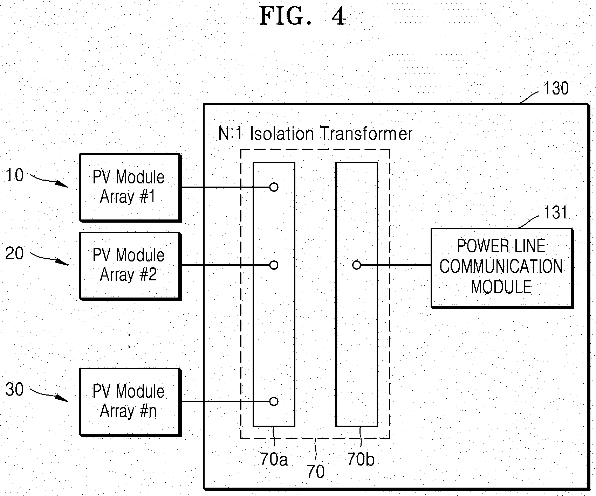

FIG. 4 is a diagram illustrating an example of a power line connection configuration of a communication unit of the control device according to an embodiment.

Referring to FIG. 4, the photovoltaic module arrays 10, 20, and 30 are connected to the communication unit 130 of the control device 100 and may transmit data for the photovoltaic modules to the control device 100.

For example, the communication unit 130 may include the PLC module 131 and the coupling unit 70.

The coupling unit 70 is connected to the photovoltaic module arrays 10, 20, and 30 through power lines 270 and may transmit a signal to the PLC module 131. That is, the coupling unit 70 may connect the photovoltaic module arrays 10, 20, and 30 to the processor 110 in a many-to-one manner.

For example, the coupling unit 70 may include an isolation transformer. In some embodiments, the coupling unit 70 may include an isolation element (not shown).

For example, one end 70a of the coupling unit 70 may be connected to the output terminal of the photovoltaic module arrays 10, 20, and 30. In some embodiments, another end 70b of the coupling unit 70 may be connected to the PLC module 131.

The control device 100 may directly receive data from the photovoltaic module arrays 10, 20, and 30 by connecting to the photovoltaic module arrays 10, 20, and 30 through the coupling unit 70. Accordingly, the complex communication structure of conventional photovoltaic power generation systems may be improved.

A communication signal received at one end of the coupling unit 70 may be transmitted to the other end.

Since the coupling unit 70 includes an isolation element or an isolation transformer, unnecessary signal interference that may occur when the communication signal is transmitted may be blocked. In some embodiments, the control device 100 may receive the communication signal with unnecessary power or noise blocked through the isolation performance of the coupling unit 70. Therefore, the quality of communication signals may be improved.

The communication unit 130 may independently transmit and receive data to and from each of the photovoltaic module arrays 10, 20, and 30 through the coupling unit 70. In some embodiments, the communication unit 130 may independently transmit and receive data to and from each of the photovoltaic modules.

The processor 110 may perform monitoring of photovoltaic modules based on data received from the photovoltaic module arrays 10, 20, and 30.

Therefore, the control device 100 may identify the operation status and control the operation by each photovoltaic module array unit through the coupling unit 70. In some embodiments, the control device 100 may identify the operation status and control the operation by each photovoltaic module unit through the coupling unit 70.

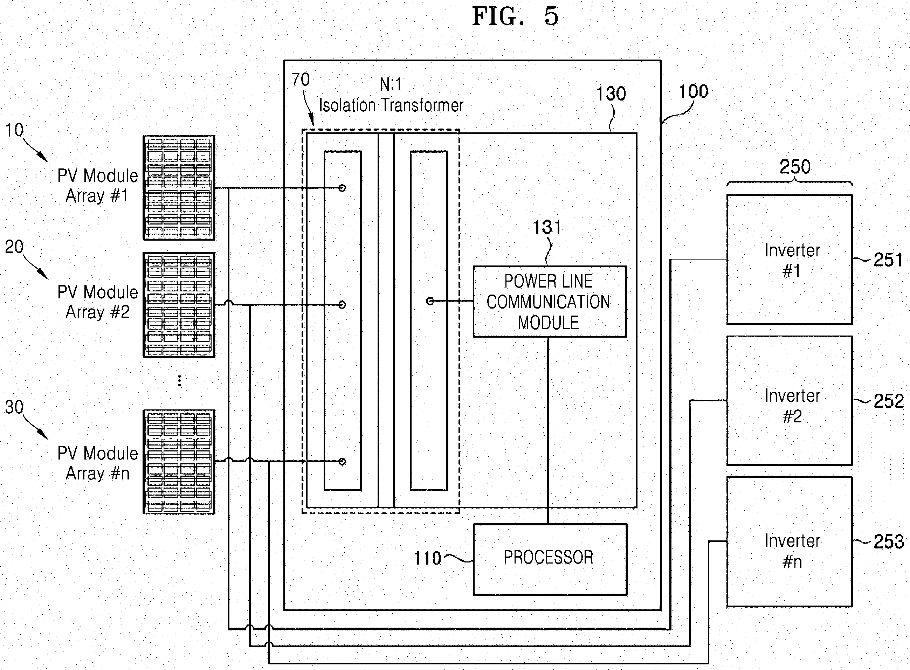

FIG. 5 is a diagram illustrating an example of a system including the control device, the photovoltaic module, the photovoltaic module array, and an inverter according to an embodiment.

Referring to FIG. 5, one end of the coupling unit 70 may be connected to 10 to 30 photovoltaic module arrays, and the other end may be connected to the PLC module 131.

The coupling unit 70 may block power or noise from among signals transmitted from 10 to 30 photovoltaic module arrays and transmit signals to the PLC module 131.

Therefore, since the control device 100 may be connected to and communicate with 10 to 30 photovoltaic module arrays, data about the photovoltaic modules may be collected.

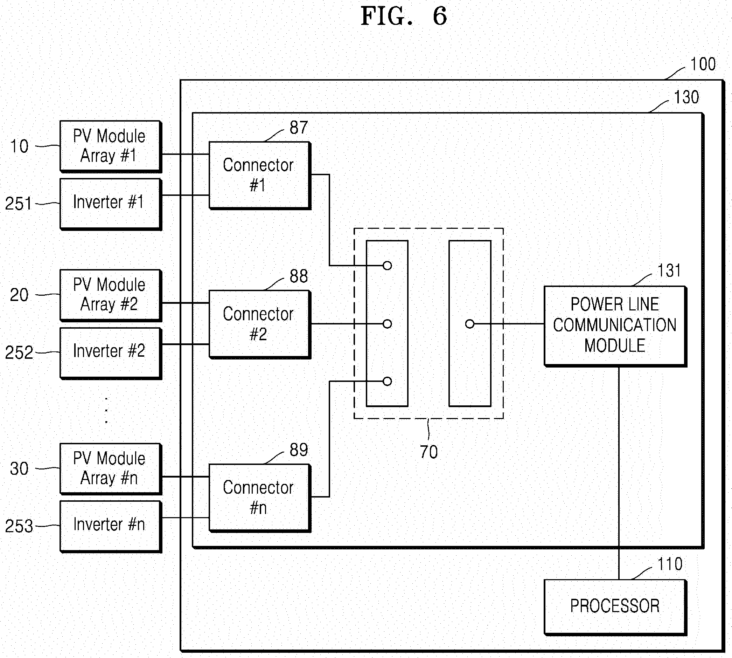

FIG. 6 is a diagram illustrating an example of the communication unit and the processor of a control device according to an embodiment.

Referring to FIG. 6, the control device 100 may include the communication unit 130 and the processor 110.

For example, the communication unit 130 may include the coupling unit 70, the PLC module 131 and a plurality of connectors 87 to 89. In some embodiments, the coupling unit 70 and the plurality of connectors 87 to 89 may be provided on the outside of the communication unit 130 and may serve as an input/output interface that processes signal input/output of the communication unit 130.

The plurality of connectors 87 to 89 may be connected to the coupling unit 70. For example, each of the plurality of connectors 87 to 89 may be connected to a single photovoltaic module array and a single inverter.

Referring to FIG. 6, the first connector 87 may be connected to the first photovoltaic module array 10 and the first inverter 251. In some embodiments, the second connector 88 may be connected to the second photovoltaic module array 20 and the second inverter 252. In some embodiments, the third connector 89 may be connected to the third photovoltaic module array 30 and the third inverter 253.

The PLC module 131 transmits data received through the coupling unit 70 to the processor 110.

The processor 110 may store the received data in the memory 120 and analyze data for the photovoltaic modules and 10 to 30 photovoltaic module arrays, and thus, monitoring of the photovoltaic modules and 10 to 30 photovoltaic module arrays may be performed.

In some embodiments, when the malfunction signal is received from the MLPE of the photovoltaic module, the processor 110 may display the malfunctioning photovoltaic module through the output unit 180.

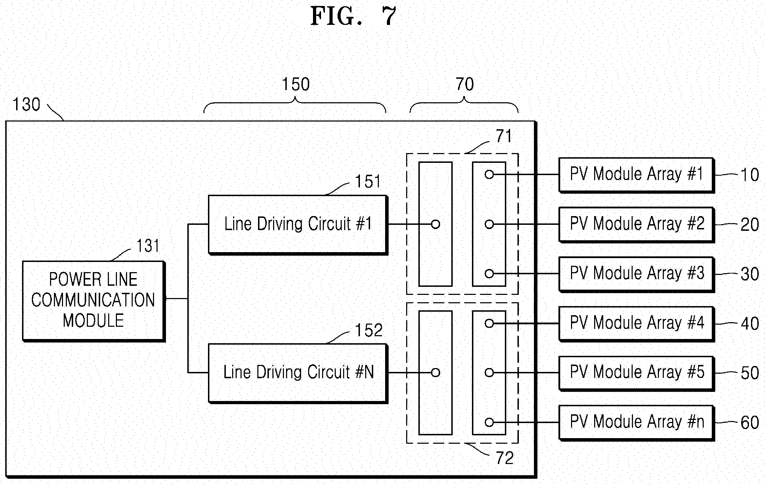

FIG. 7 is a diagram illustrating an example of the control device including a signal amplifier according to an embodiment.

Referring to FIG. 7, the control device 100 may further include the signal amplifier 150.

The signal amplifier 150 may be included in the communication unit 130. For example, the signal amplifier 150 may be located between the coupling unit 70 and the PLC module 131. In some embodiments, the signal amplifier 150 may be implemented as a device independent of the communication unit 130. When the signal amplifier 150 is an independent device, the signal amplifier 150 may be arranged between the coupling unit 70 and the photovoltaic modules.

The signal amplifier 150 may amplify a signal transmitted from the PLC module 131 to the photovoltaic module arrays 10 to 60.

Therefore, the photovoltaic module arrays 10 to 60 may receive signals with enhanced signal strength.

For example, the signal amplifier 150 may include line driving circuits 151 and 152. The line driving circuits 151 and 152 may include at least one of a drive amplifier and a buffer.

Referring to FIG. 7, the first line driving circuit 151 may be connected to the first photovoltaic module array 10 to the third photovoltaic module array 30 through the first coupling unit 71.

In some embodiments, the second line driving circuit 152 may be connected to the fourth photovoltaic module array 40 to the sixth photovoltaic module array 60 through the second coupling unit 72.

At least one line driving circuit 151 and 152 may be provided according to the number of photovoltaic module arrays 10 to 60. In some embodiments, FIG. 7 illustrates that the single line driving circuit is connected to three photovoltaic module arrays, but is not limited thereto. In other words, according to the design of the photovoltaic power generation systems, the number of photovoltaic module arrays connected to the single line driving circuit may vary.

The line driving circuits 151 and 152 may be connected to the PLC module 131. The line driving circuits 151 and 152 may amplify signals received from photovoltaic module arrays 10 to 60 through the coupling unit 70, and thus, the signals may be transmitted to the PLC module 131.

Therefore, the control device 100 may control the strength of the signal through the signal amplifier 150, and thus, signals of individual photovoltaic modules included in the plurality of photovoltaic module arrays 10 to 60 connected through the power line may be normally received by the control device 100. In some embodiments, the control device 100 may transmit signals to individual photovoltaic modules. In some embodiments, the control device 100 may improve the efficiency of communication through power lines.

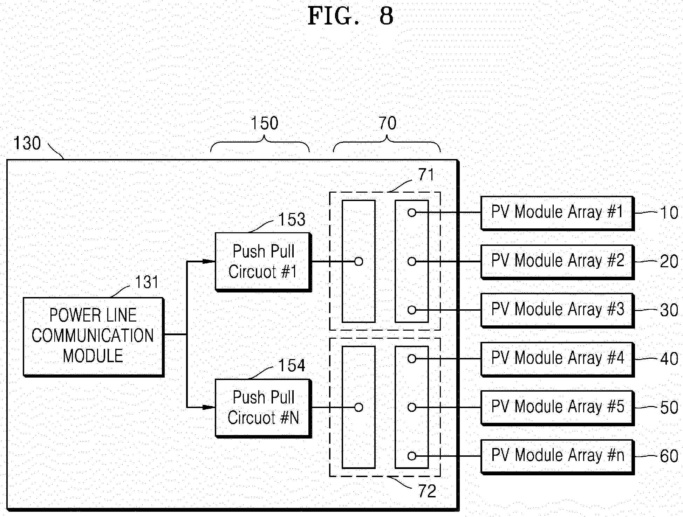

FIG. 8 is a diagram illustrating another example of the control device including the signal amplifier according to an embodiment.

Referring to FIG. 8, the communication unit 130 may include the signal amplifier 150. For example, the signal amplifier 150 may be located between the coupling unit 70 and the PLC module 131.

The signal amplifier 150 may amplify signals transmitted and received between the photovoltaic module arrays 10 to 60 and the PLC module 131.

For example, the signal amplifier 150 may include a first push-pull circuit 153 and a second push-pull circuit 154. At least one push-pull circuit 153 and 154 may be provided according to the number of photovoltaic module arrays 10 to 60. In some embodiments, FIG. 8 illustrates that the single push-pull circuit is connected to three photovoltaic module arrays, but is not limited thereto. In other words, according to the design of the photovoltaic power generation systems, the number of photovoltaic module arrays connected to the single push-pull circuit may vary.

For example, the push-pull circuit is a circuit in which two amplifiers are connected to operate complementarily with each other and may amplify signals transmitted and received through the power line communication.

Referring to FIG. 8, the first push-pull circuit 153 may be connected to 10 to 30 photovoltaic module arrays through the first coupling unit 71. In some embodiments, the second push-pull circuit 154 may be connected to the photovoltaic module arrays 40 to 60 through the second coupling unit 72.

The push-pull circuits 153 and 154 may amplify the signal of the PLC module 131 and transmit it to the coupling unit 70.

In some embodiments, the push-pull circuits 153 and 154 may amplify signals of photovoltaic module arrays 10 to 60 received through the coupling unit 70, and thus, the signals may be transmitted to the PLC module 131.

Therefore, the communication unit 130 transmits the amplified signal through the signal amplifier 150, and thus, a signal having a strength greater than a certain size may be transmitted to N power lines connected to the photovoltaic module arrays 10 to 60. (Here, N is a natural number greater than or equal to 1)

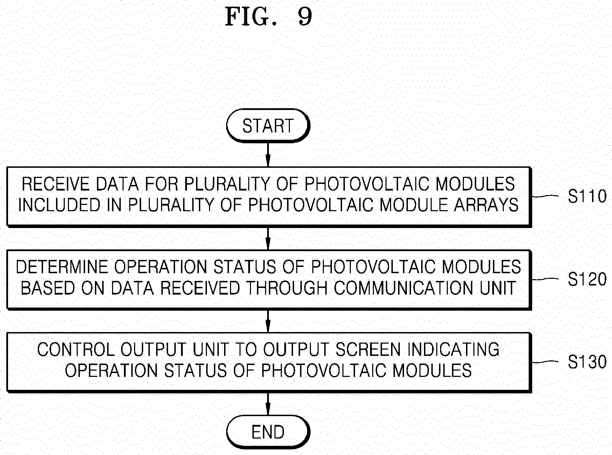

FIG. 9 is a flowchart illustrating an example of a method of controlling photovoltaic modules according to an embodiment.

The flowchart illustrated in FIG. 9 illustrates an example of a method by which the control device 100 controls photovoltaic modules. Therefore, even if the content is omitted below, the matters described above with reference to FIGS. 1 to 8 may also be applied to the operation of the control device 100 described later with reference to FIG. 9.

The communication unit 130 may receive data for the plurality of photovoltaic modules included in the plurality of photovoltaic module arrays (S110). Here, the communication unit 130 may connect the plurality of photovoltaic module arrays to the processor 110 in a many-to-one manner through the coupling unit 70.

For example, the control device 100 may receive data for the photovoltaic modules through the power line communication by communicating with the photovoltaic module arrays through the communication unit 130. The communication unit 130 may receive data in a parallel communication manner from the photovoltaic module arrays through the coupling unit 70, and may transmit data to the photovoltaic module arrays. The communication unit 130 may transmit and receive signals to and from the photovoltaic module arrays by being connected to the plurality of power lines through the coupling unit 70.

The communication unit 130 may further include the signal amplifier 150 for amplifying signals transmitted and received through the plurality of power lines. For example, the signal amplifier 150 may include the line driving circuit or push-pull circuit.

The processor 110 may determine the operation status of the photovoltaic modules based on data received through the communication unit 130 (S120).

The processor 110 may control the output unit 180 to output a screen indicating the operation status of the photovoltaic modules (S130).

For example, the processor 110 may generate a screen indicating the operation status of the photovoltaic modules and photovoltaic module arrays and output it through the output unit 180. The processor 110 may calculate the amount of power generation and the average amount of power generation of photovoltaic modules and output them through the output unit. The processor 110 may output the sum of the power generation amounts of the photovoltaic module arrays through the output unit 180. In some embodiments, the processor 110 may calculate statistical data for the amount of power generation by day, week, month, and year, and statistical data for the amount of power generation by weather or season and output them through the output unit 180.

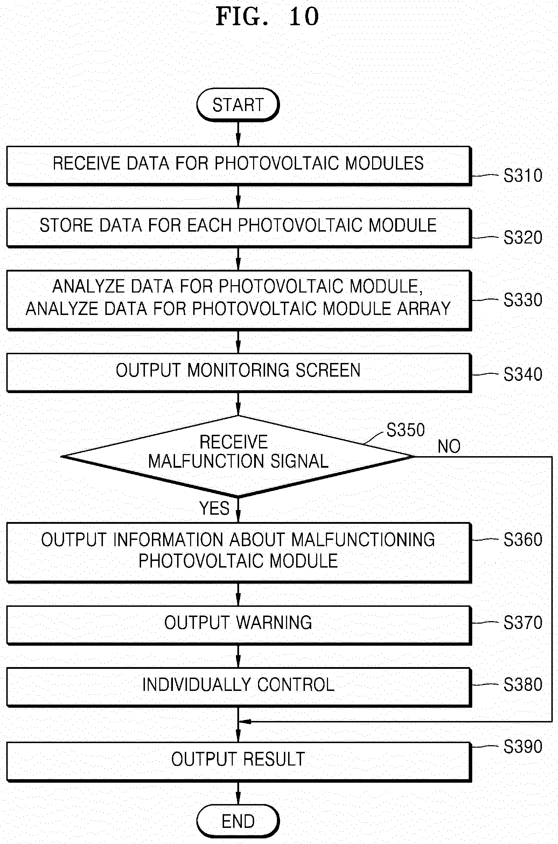

FIG. 10 is a flowchart illustrating another example of a method of controlling photovoltaic modules according to an embodiment.

The flowchart illustrated in FIG. 10 illustrates an example of a method by which the control device 100 controls photovoltaic modules. Therefore, even if omitted below, the description provided with reference to FIGS. 1 to 9 may also be applied to the operation of the control device 100 described later with reference to FIG. 10.

The control device 100 may receive data for the photovoltaic modules through the power line communication by communicating with the photovoltaic module arrays through the communication unit 130 (S310).

For example, the communication unit 130 may receive data in a parallel communication manner through the photovoltaic module arrays and the coupling unit 70, and may transmit data to the photovoltaic module arrays. The communication unit 130 may transmit and receive signals to and from the photovoltaic module arrays by being connected to the plurality of power lines through the coupling unit 70.

For example, the communication unit 130 may further include the signal amplifier 150 for amplifying signals transmitted and received through the plurality of power lines. The signal amplifier 150 may include the line driving circuit or push-pull circuit.

The processor 110 may store data for each photovoltaic module array or each photovoltaic module in the memory 120 (S320).

The processor 110 may analyze data for the photovoltaic module or photovoltaic module array (S330) and generate data about the amount of power generation of each photovoltaic module.

The processor 110 may generate a monitoring screen using data for photovoltaic modules and photovoltaic module arrays and output the monitoring screen through the output unit 180 (S340).

For example, the processor 110 may calculate the amount of power generation and the average amount of power generation of the photovoltaic module and output the calculated information through the monitoring screen. In some embodiments, the processor 110 may calculate the sum of the power generation of the photovoltaic module arrays and output the calculated information through the monitoring screen. In some embodiments, the processor 110 may calculate statistical data for the amount of power generation by day, week, month, and year, and statistical data for the amount of power generation by weather or season and output the calculated information through the monitoring screen.

In some embodiments, when a malfunction signal is received through the communication unit 130 (S350), the processor 110 may identify a malfunctioning photovoltaic module through the ID or identifier included in the malfunction signal and output information about the malfunctioning photovoltaic module through the output unit 180 (S360).

For example, according to the degree of the malfunction, some of the operations that the photovoltaic module may perform may be limited or the operation of the photovoltaic module may be stopped by a rapid shutdown function. At this time, the malfunctioning photovoltaic module may transmit the malfunction signal to the control device 100.

The processor 110 may generate a warning about the malfunctioning photovoltaic module and output it through the output unit 180 (S370).

The processor 110 may transmit a signal to control the operation of the remaining photovoltaic modules excluding the malfunctioning photovoltaic modules among all photovoltaic modules (S380).

The communication unit 130 may transmit signals to the photovoltaic module arrays through the coupling unit 70. For example, the communication unit 130 may transmit an amplified signal to the photovoltaic module arrays through the signal amplifier 150.

When response data to the control signal is received, the processor 110 may control the output unit 180 to output data about the photovoltaic modules (S390).

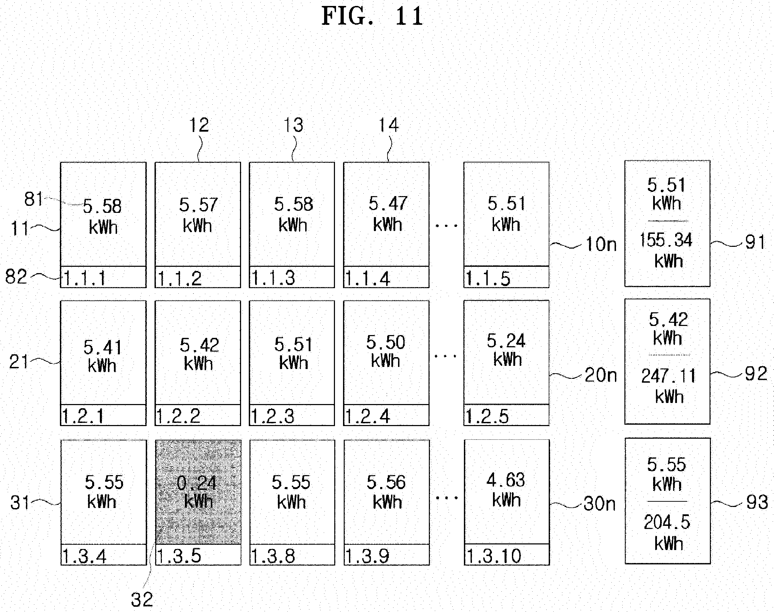

FIG. 11 is a diagram illustrating an example of a monitoring screen regarding an integrated control device for photovoltaic modules according to an embodiment.

Referring to FIG. 11, the control device 100 may generate a monitoring screen based on data for photovoltaic module arrays and photovoltaic modules received through the communication unit 130 and output the monitoring screen through the output unit 180.

For example, the processor 110 may analyze data for photovoltaic modules 11 through 10n, 21 through 20N, and 31 through 30n and display the amount of power generation 81 of each photovoltaic module.

In some embodiments, the processor 110 may display an identifier 82 to distinguish each photovoltaic module 11 through 10n, 21 through 20n, and 31 through 30n. For example, identifiers may include an address, product number, serial number, etc. assigned to each photovoltaic module.

In some embodiments, the processor 110 may calculate the total amount of power generation and the average amount of power generation of the photovoltaic module array composed of photovoltaic modules 11 through 15, 21 through 20n, and 31 through 30n.

The output unit 180 may display the power generation information 91, 92, and 93 of the photovoltaic module array through the monitoring screen according to the calculated result of the processor 110.

In some embodiments, the processor 110 may identify a malfunctioning photovoltaic module 32 for which a malfunction signal has been received and display the malfunctioning photovoltaic module 32 differently from other photovoltaic modules on the monitoring screen. For example, the output unit 180 may display the color or background color of the malfunctioning photovoltaic module 32 differently from other photovoltaic modules in response to the control signal of the processor 110.

In some embodiments, the processor 110 may generate a warning about the malfunctioning photovoltaic module 32 and output it through the output unit 180.

As described above with reference to FIGS. 1 to 11, since the control device 100 is connected to the plurality of photovoltaic module arrays through the coupling unit, the control device 100 may receive the communication signal with unnecessary power or noise blocked. Therefore, the quality of communication signals may be improved. In some embodiments, since the plurality of photovoltaic module arrays communicate with the control device 100, it is possible to simplify the structure for communication and control and reduce complexity compared to conventional photovoltaic power generation systems.

In some embodiments, the above-described method may be implemented in a general purpose digital computer that operates the program by using a computer-readable recording medium that may be written as a program that may be executed on a computer. In some embodiments, the structure of the data used in the above-described method may be recorded on a computer-readable recording medium through various means. The computer-readable recording medium includes storage medium such as magnetic storage medium (e.g., ROM, RAM, USB, floppy disk, hard disk, etc.) and optical readable medium (e.g., CD-ROM, DVD, etc.).

The present disclosure has been described with reference to the embodiments illustrated in the drawings, but these are merely exemplary, and it will be understood by those of ordinary skill in the art that various changes and other equivalent embodiments are possible from the above embodiments. Therefore, the scope of the present disclosure should be defined by the following claims.

## Claims

1. A device for controlling a photovoltaic module, the device comprising:
a communication unit configured to receive data from a plurality of photovoltaic modules included in a plurality of photovoltaic module arrays; and
a processor configured to monitor and control an operation status of the plurality of photovoltaic modules based on data received through the communication unit,
wherein the communication unit comprises
a coupling unit configured to connect the plurality of photovoltaic module arrays to the processor in a many-to-one manner.

2. The device of claim 1, wherein
opposite ends of the coupling unit are respectively connected to output terminals of the plurality of photovoltaic module arrays and a power line communication module,
a signal applied to one of the opposite ends is transmitted to the other end.

3. The device of claim 1, wherein
the coupling unit comprises
at least one of an isolation transformer and an isolation element.

4. The device of claim 1, wherein
the processor is further configured to
distinguish the plurality of photovoltaic modules based on an identifier assigned to each of the plurality of photovoltaic modules and
monitor the operation status by processing data for each of the plurality of photovoltaic modules.

5. The device of claim 1, wherein
the processor is further configured to output
information about a malfunctioning photovoltaic module based on a malfunction signal received when a rapid shutdown (RSD) function is executed in at least one of the plurality of photovoltaic modules.

6. The device of claim 1, wherein
each of the plurality of photovoltaic modules comprises
module level power electronics (MLPE) performing monitoring and rapid shutdown functions.

7. The device of claim 1, wherein
the communication unit further comprises
a plurality of connectors, having opposite ends, respectively connected to the photovoltaic module arrays and the coupling unit.

8. The device of claim 1, wherein
the communication unit further comprises:
a signal amplifier which is connected between the communication unit and the plurality of photovoltaic module arrays to amplify signals; and
a power line communication module.

9. The device of claim 8, wherein the signal amplifier is connected between the coupling unit and the power line communication module.

10. The device of claim 8, wherein
the signal amplifier is provided in such a number
corresponding to the number of the photovoltaic module arrays.

11. The device of claim 8, wherein
the signal amplifier is configured to be as a line driving circuit and amplify signals of the power line communication module and transmit amplified signals to the plurality of photovoltaic module arrays.

12. The device of claim 11, wherein
the signal amplifier comprises
at least one of a drive amplifier and a buffer.

13. The device of claim 8, wherein
the signal amplifier comprises
a push-pull circuit in which two amplifiers are connected to operate complementarily with each other.

14. A method of controlling photovoltaic modules, the method comprising:
receiving, by a communication unit, data from a plurality of photovoltaic modules included in a plurality of photovoltaic module arrays;
determining, by the processor, the operation status of the photovoltaic modules based on data received through the communication unit; and
controlling, by the processor, an output unit to output a screen indicating the operation status of the photovoltaic modules, wherein the communication unit
connects the plurality of photovoltaic module arrays to the processor in a many-to-one manner through the coupling unit.

15. The method of claim 14, wherein
the communication unit connects the plurality of photovoltaic module arrays to the processor through N power lines,
the N corresponds to the number of the plurality of photovoltaic module arrays.

16. The method of claim 14, wherein
the determining comprises:
distinguishing, by the processor, the plurality of photovoltaic modules based on an identifier assigned to each of the plurality of photovoltaic modules; and
monitoring, by the processor, the operation status by processing data for each of the plurality of photovoltaic modules.

17. The method of claim 14, wherein
the determining comprises:
identifying, by the processor, a malfunctioning photovoltaic module according to a malfunction signal received from at least one of the plurality of photovoltaic modules; and
controlling, by the processor, the output unit to output information about the malfunctioning photovoltaic module.

18. The method of claim 14, further comprising:
generating, by the processor, individual control commands for each of the plurality of photovoltaic module arrays;
generating, by the communication unit, a communication signal for the individual control command;
amplifying, by the signal amplifier, the communication signal; and transmitting, by the coupling unit, an amplified communication signal to the plurality of photovoltaic module arrays.

19. The method of claim 18, wherein
the signal amplifier comprises
one of a line driving circuit and a push-pull circuit.

20. A computer-readable recording medium having recorded thereon a program for causing a computer to execute the method of claim 14.
